Europäisches Patentamt

European Patent Office

Office européen des brevets

(11) Publication number: **0 420 339 A2**

# EUROPEAN PATENT APPLICATION

(21) Application number: 90202525.3

(22) Date of filing: 25.09.90

(51) Int. Cl.5: **G11C 11/00, G11C 7/00**

(30) Priority: 29.09.89 US 414823

(43) Date of publication of application:
**03.04.91 Bulletin 91/14**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Willis, John Christopher**
**c/o INT. OCTROOIBUREAU B.V., Prof.**
**Holstlaan 6**
**NL-5656 AA Eindhoven(NL)**
Inventor: **Marshall, Thomas**
**c/o INT. OCTROOIBUREAU B.V., Prof.**
**Holstlaan 6**
**NL-5656 AA Eindhoven(NL)**

(74) Representative: **Strijland, Wilfred et al**
**INTERNATIONAAL OCTROOIBUREAU B.V.**
**Prof. Holstlaan 6**
**NL-5656 AA Eindhoven(NL)**

(54) Multi-plane random access memory system.

(57) A memory having a plurality of random access memory planes, and common bit lines extending between the memory planes. Copy circuits enable simultaneously copying a plurality of data bits from one memory plane to another through the common bit lines. Each memory plane can be read and written to independently of the others.

FIG.1A

## MULTI-PLANE RANDOM ACCESS MEMORY SYSTEM

The present invention relates to random access memories, and more particularly to a multi-plane random access memory system.

Various types of memory devices having multiple memory regions with copy capability between them are known. These known devices can be classified under the categories: dual port registers, dual port memory, video memory, and shadow mask memory.

Dual or multi-port register files allow write operations to only one port, although parallel read operations from two or more ports are possible. In one type, write operations can be controlled from a unique port, and another type permits one of the ports to be used for both reading and writing. Information written at one port is always readable from all of the other ports on the following clock cycle, with granularity equal to the minimum addressable unit, e.g. one, two, four, eight or sixteen bits. Internally, multi-port register files typically replicate a memory array for each of the read ports to permit parallel access. One application of multi-port register files is the construction of processor register files.

Dual or multi-port memory devices permit write operations to any port by serializing access to a single memory array. Structurally, these devices do not have multiple memory planes although in a sense they emulate multi-plane devices. If one port is reading or writing the memory array, access from any other port will be deferred by one or more memory cycles. Like the multi-port register file, information written through one port is always readable from all of the other ports on the following clock cycle with granularity equal to the minimum addressble unit. Unlike multi-port register files, multi-port memory devices may be written to from any port. These devices are typically used for communication between processors in a multiprocessor system.

Video memory devices comprise two physically distinct memory planes; a random access memory array and a shift register array. The random access memory array is comprised of a plurality of memory cells arranged in a matrix of n rows by m volumns which can be randomly read or written from one port. The shift register, typically m bits in length, is connected in parallel to columns of the random access memory array and in series with output ports, and optionally input ports. The copying granularity is fixed by the row length. The second plane has storage limited to one row, and the only access patterns supported are sequences, beginning with the firs bit in a row. Although video memory devices were originally intended to support bit-mapped graphics, they have founf application in multiprocessor systems.

Shadow memory devices are comprised of two physically distinct memory planes; a static random access memory (SRAM) array, and an electronically erasable programmable read only memory (EEPROM) array. Copy operations allow parallel copying between the entire SRAM plane and the EEPROM plane. The first plane is directly accessible to external devices through a port. The second plane is only indirectly accessible via recall operations back into the first SRAM plane. Examples of this structure are disclosed in U.S. Patents 4,545,035 and 4,609,999. Shadow memory devices are intended for nonvolatile storage in embedded applications where temporary copies may be kept of a slowly changing reference. Copy operations are not possible over selectable regions of the memory array and no bandwidth advantage is achieved by the second plane.

It would be highly desirable to have a multi-plane random access memory system in which each of the memory planes are comprised of RAM, in which each plane of the device is connected to a distinct port through which read and write operations to that plane can be carried out, and in which the content of multiple memory cells in one plane can be copied simultaneously to another memory plane of the system.

A multi-plane memory system could find many applications in parallel processor computer systems. The multi-plane memory could allow entire memory structures to be communicated among a number of processors with lower contention, lower latency and greater flexibility than any of the known devices just described.

The use of a multi-plane memory to support fine grain parallel processing can provide conflict-free access for each arithmetic logic unit until a well-defined synchronization event occurs, when intermediate results could be copied into another processor's memory plane as an atomic operation. A multi-plane memory can also be used to couple a primary processor with one or more co-processors. Operation code and arguments for an instruction can be assembled in one plane of the memory while co-processors use the contents of other planes to complete prior instructions. New operation code and argument structures can then be supplied to a co-processor in a single clock cycle and a block copy between planes. Likewise information can be sent back to the primary processor's memory plane as a single block copy.

A multi-plane memory can also be used in a cached computer system as a cache buffer to support simultaneous access by both the processor and the cache controller. In most cache designs the traffic between processor and cache is much greater than the traffic between cache and main memory through the cache controller, suggesting the desirability of using a three of four port memory design where all but one of the ports are used for traffic between the processor and the cache. Planes connected to the processor might support instruction caching, data caching and stack caching while one port would support the cache controller. If any of the processor ports miss a block, a request would go to the cache controller to load the block into the controller's plane. With the block fully loaded, it would be copied, inside the multi-plane memory, into the cache needing the block. This operation could be carried out with other planes of the multi-plane memory continuing to service other instruction streams running on the processor.

Intelligent peripheral processors used to off-load input/output operations from general purpose processors frequently use main memory as a storage buffer. The use of a multi-plane memory could reduce contention for main memory with these devices.

## SUMMARY OF THE INVENTION

Accordingly, it is an object of the invention to provide a multi-plane random access memory system which includes a plurality of random access memory planes.

Another object of the invention is to provide a multi-plane random access memory system in which each random access memory plane has its own port and can be read and written to through that port independently of the other planes.

Another object of the invention is to provide a multi-plane random access memory system in which the content of a plurality of memory cells in one plane can be simultaneously copied to another memory plane.

Another object of the invention is to provide a random access memory plane for use in a multi-plane memory system.

Another object of the invention is to provide a multi-plane random access memory system in a parallel processor computer system.

A multi-plane random access memory system according to the invention is comprised of a plurality of random access memory planes each comprised of an array of memory cells. A plurality of read/write means each cooperate with a corresponding one of the memory planes for permitting reading from and writing to each of the correspodning memory planes independently of the other memory planes. Copying means is operable for simultaneously copying the content of selected memory cells in one memory plane to corresponding memory cells in another memory plane. In this context, corresponding is to be explained broadly in that it be determined by the physical disposition of the hardware, such as:
- all of a particular memory row is copied to a row in another plane (possibly at another row address)
- a particular block within a plane is copied to a block of like dimensions in another memory plane (possibly having relative offsets in row and/or column direction)
- another rotation, interleaving, mirroring, translation or other linear transposition as governed by cell-to cell interconnection between the respective planes.

In one embodiment of the invention the random access memory planes are dynamic memory planes comprised of dynamic memory cells. The copying means is comprised of a plurality of common bits lines each corresponding to a particular bit line in each of the memory planes tod efine a data transfer path between the corresponding bits lines in the respective memory planes, and a plurality of copy circuits each corresponding to one of the arrays of memory cells. Each copy circuit comprises an array of copy cells equal in number to the number of bit lines of the memory cell array to which the copy circuit corresponds. Each copy cell has a data signal input, a data signal output and an enable signal input. Each copy cell is connected with its data signal input to its corresponding bit line, it data signal output to the common bit line corresponding to the bit line to which the copy cell is connected, and the enable signal input receives in use an enabling signal for enabling a copy cell to connect its corresponding bit line to its corresponding common bit line for completing a data transfer path between the corresponding bit line and common bit line.

In the dynamic random access memory planes, each is comprised of an array of dynamic memory cells arranged in a matrix of rows and columns and comprises row lines and column lines for addressing individual memory cells of the memory cell array, and bit lines for providing access to the respective memory cells being addressed. Each of the read/write means is comprised of row addressing means for addressing a row of the matrix, and column addressing means for simultaneously addressing a selectable number of columns of the matrix. The column addressing means is comprised of means responsive to a size signal for setting the number of columns to be addressed, means responsive to an address signal for generating column selection signals for the columns to be addressed, and means comprised of signal paths for applying the column selection signals to simultaneously enable the corresponding copy cells of the columns being addressed thereby connecting the bit lines of the memory cells to their corresponding common bit lines.

The multi-plane static random access memory system according to the invention differs from the dynamic memeory embodiment. In the static memory system the memory cells in each plane are in one-to-one correspondence, and all of the corresponding memory cells in the memory planes share the same common bit line. The common bit lines between the memory planes are not connectable to the bit lines within a memory plane; instead they can be connected directly to the memory cells so that more than one row of memory at a time can be copied between memory planes.

## BRIEF DESCRIPTION OF THE DRAWING

Figs. 1A and 1B illustrate two embodiments of a multi-plane memory system according to the invention;

Fig. 2 illustrates a random access memory plane according to the invention;

Fig. 3 illustrates the column decoder circuit used in the memory plane of Fig. 2;

Fig. 4 illustrates the copy circuit used in the memory plane of Fig. 2;

Fig. 5 illustrates the circuit of a static memory cell for a multi-plane SCRAM according to the invention; and

Fig. 6 illustrates a parallel multiprocessor computer system incorporating the multi-plane memory system according to the invention.

## DETAILED DESCRIPTION OF THE INVENTION

In the following description of the invention, the same structural elements, or corresponding elements where appropriate, included in different embodiments will be referred to by the same reference numeral.

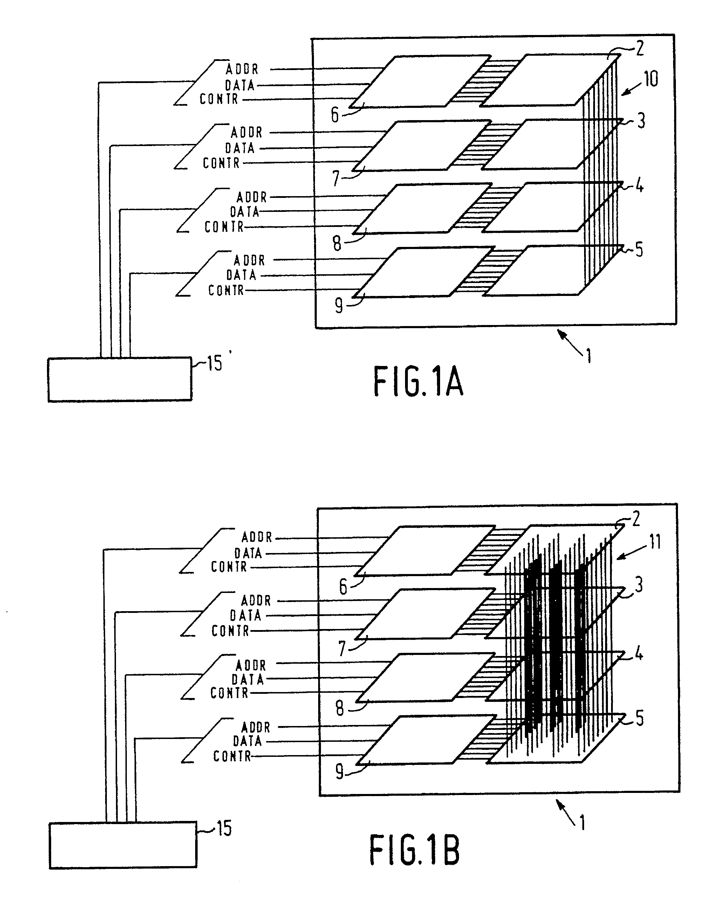

A first embodiment shown in Fig. 1A of the multi-plane memory system 1 is comprised of random access memory planes 2, 3, 4 and 5. Each memory plane has a corresponding read/write port 6, 7, 8, 9 which defines a unique port for reading and writing to the corresponding memory plane. Each memory plane in independently addressable through its read/write port, and each can be addressed as a random access memory.

Data transfer paths between the memory planes 2-5 are defined by a plurality of common bit lines 10. The structure for copying data from one memory plane to another through the common bit lines 10 is described in further detail, below. At this point, it is sufficient to point out that the embodiment of Fig. 1A includes the plurality of bit lines 10 corresponding to a row of memory cells within each memory plane, and data copying can occur simultaneously for up to an entire row of memory cells. The embodiment shown in Fig. 1B differs in that it includes a plurality of common bit lines 11, each corresponding to an individual memory cell within the respective memory planes 2-5. In this embodiment, the entire content of one memory plane can be simultaneously copied to another of the memory planes as an atomic operation.

The respective read/write ports 6-9 receive and transmit data to an external system, and receive address signals and control signals from the system. Control of copy operations between the memory planes for avoiding conflicts will be controlled by the system, by some external arbiter 15.

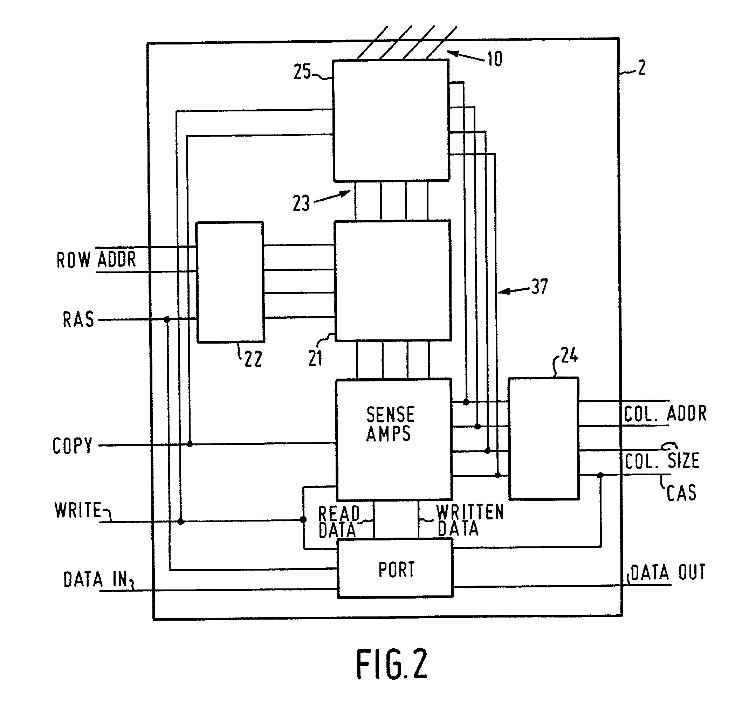

Fig. 2 illustrates the structure of one of the memory planes. A memory array 21 is comprised of a plurality of memory cells for storing binary values. The memory cells of the array are conventional dynamic memory cells arranged in a matrix of rows and columns, and the rows and columns are individually addressable. All of the memory cells disposed in a particular row within the memory array 21 are selected by the row decoder 22 in response to a row address signal and a row address strobe (RAS) signal. Each column of memory cells share one of the plurality of bit lines 23 with a sense amplifier and a bit copy cell of the copy circuit 25.

Columns of memory cells and their associated bit lines are selected by a column decoder 24. The column decoder 24 receives a column address signal, a size·signal and a column address strobe (CAS) signal. Selection of a particular bit line, or plurality of bit lines by the column decoder 24 allows the signal value on the bit lines, which is the memory content of the memory cells, to be replaced by a new value in the manner described below.

The column decoder 24 differs from conventional column decoders used in single plane memories. In

4

the multi-plane memory system the column decoder is capable of simultaneously selecting more than one of the columns, based on the size signal supplied to it along with the address and strobe signals. The copy circuit 25 connects a selected bit line of the memory matrix 21 with a corresponding one of the common bit lines 10 which extend between the several memory planes. This connection is made through a bi-directional pass transistor as later described in detail.

The column decoder circuit 24 of the multi-plane memory system is capable of selecting more than one output at the same time by ignoring low order address bits. In order to select more than one bit line at a time, the column decoder 24 requires an additional size signal input. The size signal input, M bits, specifies the number of address bits which are to be interpreted as don't care bits during column selection, beginning with the least significant bit. If the size signal bits, interpreted as an unsigned integer, are zero, the bit line for only one column is selected as in a conventional column decoder. If the size signal is one, two columns which differ only in their least significant bit are selected. If the size is two, four columns are selected, differing only in the least two bits. Likewise, larger segments may be selected within the row aligned on binary boundaries. In order for blocks of data to be transferred between memory planes in a contiguous block, the column address must represent the least significant bits of the address.

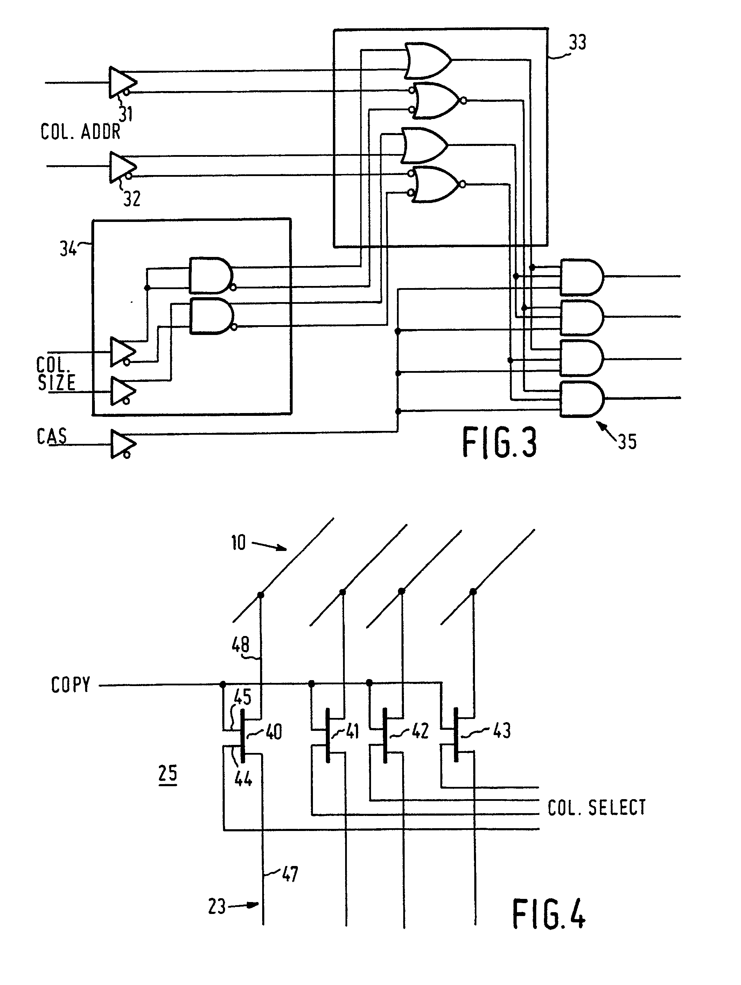

Fig. 3 shows the circuit diagram for the column decoder 24. Conventional high speed decoders are usually designed with a true and complement address signal buffer for each address line. The address signal buffers drive one AND or OR gate per selection line. So that a desired input address will trigger the AND or OR gate output condition, resulting in the AND gate going high or the OR gate going low to indicate the selection. The column decoders according to the invention require additional circuits for the multi-plane memory so that progressive low order address bits may be ignored in the selection.

The address signal is applied to address signal buffers 31, 32 which are true and complement buffers. The buffer output signals are applied to an address mask 33 which also receives signals from the size signal decoder 34. The output signals from the address mask 33 are applied to a plurality of selection gates 35, in this case AND gates. The output signals of the selection gates 35 are applied to column selection lines 37 for selecting bit lines corresponding to columns of the memory array 21.

The mode of operation of the column decoder 24 can be readily understood from inspection of the following state table for the circuit illustrated which can select up to four columns.

| STROBE SIGNAL | SIZE SIGNAL | ADDRESS SIGNAL | COLUMN SELECT |
|---|---|---|---|
| 0 | XX | XX | 0000 |
| 1 | 00 | XX | 0000 |
| 1 | 01 | 00 | 0001 |
| 1 | 01 | 01 | 0010 |
| 1 | 01 | 10 | 0100 |
| 1 | 01 | 11 | 1000 |
| 1 | 10 | 0X | 0011 |
| 1 | 10 | 1X | 1100 |
| 1 | 11 | XX | 1111 |

In the table, the symbol "X" indicates a don't care condition; otherwiae the signals represented assume the binary values zero or one. The first case of a zero strobe signal is trivial; no columns are selected. The second case of a one strobe signal and 00 size signal also results in the selection of no columns. When the strobe signal is 1 and the address size signal is 01, the circuit operates like a conventional column decoder. That is, each different address signal selects one unique column.

The new mode of operation occurs when the size signal value is 10. In this case, the least significant bit of the address signals become a don't care bit, and the columns are selected in pairs. The pairs selected are simultaneously selected so that as described below, data from those two columns may be simultaneously copied. Finally, for the four column example given, when the size signal is 11, all four columns or bit lines are selected.

The copy circuit 25 enables the multiple column select signals to be utilized for simultaneous copying of data. Its structure is shown in Fig. 4.

The copy circuit 25 is an array of copy cells each comprised of one of the dual gate bi-directional pass transistors 40, 41, 42 and 43. Alternatively, the dual gate transistors could each be replaced by a pair of signal gate transistors in series. Each of the transistors 40-43 corresponds to a particular one of the common bit lines 10 and a particular one of the bit lines 23. When a particular pass transistor is rendered conductive, it completes a data transfer path from its corresponding bit line to its corresponding common bit line thereby providing access to the memory cell of the memory array 21 which is connected to the selected bit line.

Bit line selection occurs by applying a column select signal to one of the pass transistors. For example, the transistor 40 has gate terminals 44 and 45. A column select signal applied to the gate 44 of the transistor 40 will be effective to select the bit line 47 corresponding to the transistor 40. Next, when a copy signal is applied to the second gate terminal 45, the transistor will be rendered conductive and the corresponding common bit line 48 will be connected through the transistor 40 to the corresponding bit line 47 thereby completing a data transfer path from the bit line 47 to the common bit line 48.

The common bit lines 10 comprise means by which information may be copied between memory planes of the multi-plane memory system. Each common bit line corresponds to one unique column in each of the memory planes. During a single cycle of memory operation, this one-to-one correspondence allows a block transfer between a row in one memory plane and a row in another memory plane within the multi-plane memory system. The block transfer involves copying from zero bits up to the full length of the row, with the set of copied bits aligned on a binary boundary, and being a binary multiple in length.

Each of the dynamic memory planes of the multi-plane memory system is capable of five operations: read, refresh, write, read copy and write copy. The following discussion traces through each of these oprations in order to illustrate the mode of operation of the multi-plane memory system.
Reference should be made to Fig. 2.

Read operations have two principal phases. The first phase is initiated by the assertion of the row address strobe signal. The RAS enables a row of memory cells of the designated row address to gate stored values onto their associated bit lines. A sense amplifier associated with each bit detects the boolean value originating with the selected memory cell and retains it for use during the next phase. The second phase is initiated by assertion of the column address strobe. The CAS enables a sense amplifier designated by the column address to gate its stored value to the data output for external use. The second phase is terminated with the value stored in all of the sense amplifiers being amplified, gated back onto the associated bit lines and into the row of memory cells selected earlier by the RAS. Memory cells whose contenst were initially disturbed by the read operation are thus regenerated at the completion of the read operation.

Refresh operations regenerate the content of memory cells that would otherwise be disrupted by the decay processes inherent to dynamic memory cells. During refresh, the memory cells in a selected row are rewritten using a process identical to the read operation, accept that the column address strobe need never be asserted. Internal timing and logic will turn on the sense amplifiers and regenerate memory cell content without getting any values to the memory planes data output port.

The write operation is used for introducing new data into a memory plane. The first phase of a write operation is identical to that of a read operation. In the second phase of the write operation, the column selected by the column address will have the input data impressed upon it to substitute the input data value for the stored bit line value. Unselected columns are regenerated by the sense amplifiers as in the read cycle or the refresh cycle.

Blocks of data stored in the multi-plane memory can be copied between memory planes by pairing a read copy operation in one plane with a write copy operation on one or more of the other planes. The plane performing the read copy, or source plane, drives the common bits lines during the second phase of its operation, while the plane or planes performing the write copy, or target planes, receive new information from the common bit lines.

Read copy operations have two phases analogous to the simple read operation described above. During the first phase of the read copy operation, the information stored in a row of memory cells is gated onto bit lines and retained by sense amplifiers. During the second phase, columns selected by the column address signal and size signal are gated from the source plane bit lines onto the corresponding common bit lines by the circuit 25 in the manner previously described. In this way, one or more bits up to the entire row of stored data values are accessible to other planes. Moreover, the column address need not be qualified by size for a read copy operation. As long as there is sufficient power available, all of the bit lines can be gated onto the corresponding common bit lines 10 simultaneously. In parallel with the common bit lines being charged, all of the memory cells in the selected row must be regenerated.

To complete the copy operation, the read copy operation must be paired with one or more write copy operations on the target planes. Write copy operations have a first phase analogous to the read operation described above. During the second phase of the write copy operation, the column address and size signals select copy cells of the target plane to gate stored values from the common bit lines onto the target plane's bit lines. Any columns which are not selected must be driven by the associated sense amplifiers so as to regenerate any bits that are not being copied.

The multi-plane memory system according to the invention can also be realized using static random access memory (RAM). The use of SRAM permits the simultaneous copying from more than one row of memory in the source memory plane at a time. This capability arises, as shown in Fig. 1B by the availability of multiple rows of common bit lines 11 extending between all of the memory planes of the multi-plane memory system.

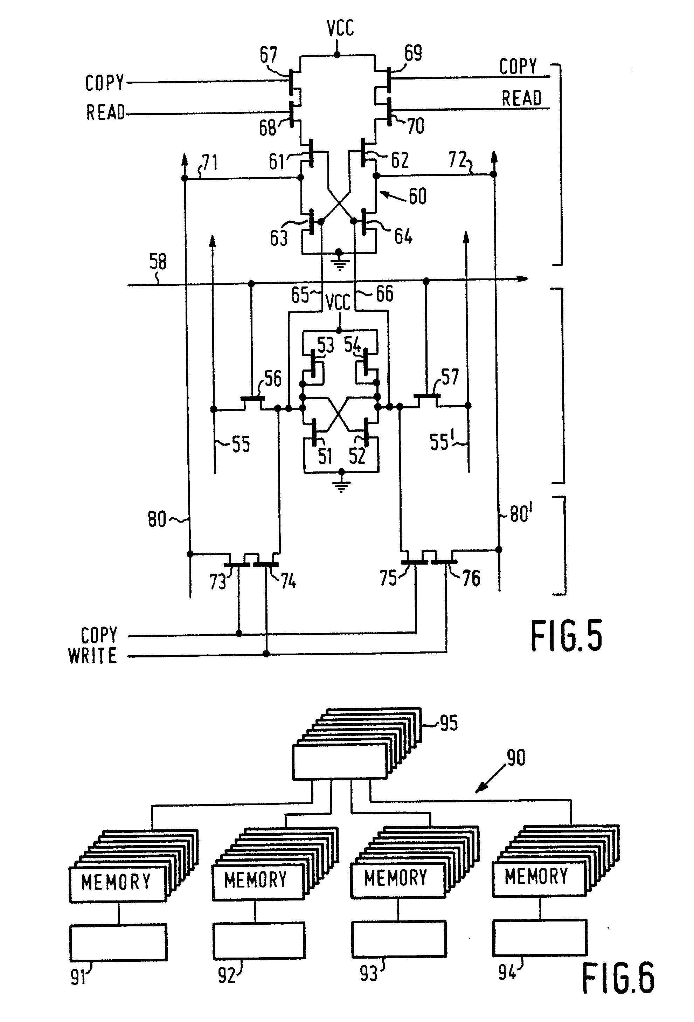

Fig. 5 shows the circuit of a memory cell used in the static random access memory plane according to the invention. This memory cell is different from conventional SRAM memory cells.

Cross-coupled transistors 51, 52 comprise a bistable device for storing a binary value. Transistors 53, 54 provide the load for the bistable transistor pair 51, 52. Conductive lines 55, 55' together define the bit line for the static memory cell. Conductor 55 receives the signal state of the transistor 51 through the pass transistor 56, while the conductor 55' receives the signal state of the transistor 52 through the pass transistor 57. The signal states applied to the conductors 55 and 55' are necessarily the logical complement of each other and the two conductors together constitute the bit line for accessing the memory content or state of the static memory cell.

The row line 58 receives a row select signal from the row decoder, and the row select signal is applied to the respective gates of the pass transistors 56, 57. This is effective to apply the memory content of the static memory cells in a selected row to their corresponding bit lines in response to a row select signal. It will be understood that the row line 58 extends to successive static memory cells of that row (not shown), just as the bit line 55, 55' extends to successive static memory cells of that column (not shown).

A read amplifier 60 is used to charge the common bit lines 80, 80' to the state stored in the memory cell without perturbing the stored state. The amplifier proper is defined by transistors 61, 62, 63 and 64. The stored memory content of the bistable circuit 51, 52 is applied through signal lines 65, 66 to the gates of the read amplifier transistors 61-64. The read amplifier further comprises transistors 67, 68, 69 and 70 which define control structure for controlling the operation of the read amplifier 60. The transistor pair 67, 68 and the transistor pair 69, 70 define respective AND gates used to turn the amplifier 60 on. Signal lines 71, 72 connect the outputs of the read amplifier 60 to the common bit line as discussed in detail, below.

A write stage comprised of transistors 73, 74, 75 and 76 allows the common bit line conductors 80, 80' to be used to set the value of the static memory cell. Transistor pairs 73, 74 and 75, 76 define respective AND gates for connecting the true and complement sides of the bi-stable circuit 51, 52 to the respective common bit line conductors 80, 80' when the copy and write inputs are asserted. A single dual gate pass transistor could be substituted for each of the transistor pairs, if desired.

Both reading a copy and writing a copy must be controlled by the output of row and column decoders like that shown in Fig. 3. This can be done by ANDing the copy line signal sent to an entire row with the associated row decoder output. Likewise, the read and write lines sent to a column of cells must be ANDed with the associated column decoder output.

Memory cells having the same row and column index in the different memory planes are connectable to the same common bit line. This common bit line defines a data transfer path used for transferring the memory content of corresponding memory cells from one memory plane to another. No more than one memory plane at a time must drive the common bit lines, thus a system that uses a multi-plane memory will have an arbiter as in the case of dynamic memory.

The physical realization of the multi-plane memory system according to the invention is easiest by fabricating each memory plane as a separate device. The common bit lines then constitute an external data path between the separate memory planes. The size of this physical embodiment would be limited by pin count considerations.

Alternatively, particularly in the case of the static memory device, substantial advantages in terms of pin count limits could be realized by fabricating the multiple memory planes in the same integrated circuit as a three-dimensional device. Stacked SRAM layers are disclosed in the article by K. Yamazaki et al, "FABRICATION TECHNOLOGIES FOR DUAL 4-KBIT STACKED SRAM", IEDM 86, pp. 435-438, IEEE 1986. The stacked memory shown in this article comprises a single memory plane folded upon itself to reduce chip area, and it is not a multi-plane memory as in the present invention. However, it does show vertically stacked memory cells operative in the same integrated circuit structure. The survey article by Y. Akasaka, "Three Dimensional IC Trends", Proc. IEEE, Vol. 74, No. 12, Dec. 1986, pp. 1703-1714, also shows at page 1709 a stacked RAM structure and at page 1713 suggests a multi-plane memory for use with multiprocessors; however, it does not suggest how to realize the circuitry for such a memory.

An actual application of the multi-plane memory according to the invention in a parallel multi-processor system, such as discussed in the Background of the Invention, is shown in Fig. 6. A multiprocessor computer system 90 includes independent processors 91, 92, 93 and 94. Each processor is connected for reading and writing to the multi-plane random access memory system 95 according to the invention. Arbitration among the different processors 91-94 can advantageously be part of the system programming of the overall system, or it can be done through the particular application programs being run by the respective processors. The processors 91-94 can address the respective memory planes of the multi-plane memory 95, and the multi-plane memory can copy data between its respective memory planes in the manner described in detail, above.

## Claims

1. A multi-plane random access memory system, comprising:
a plurality of random access memory planes each comprised of an array of memory cells;
a plurality of read/write means each cooperative with a corresponding one of said memory planes for permitting reading from and writing to each of said corresponding memory planes independently of the other of said memory plane; and
copying means operable for simultaneously copying the content of selected memory cells in one memory plane to corresponding memory cells in another memory plane.

2. A multi-plane random access memory system according to Claim 1, wherein said random access memory planes are comprised of arrays of dynamic memory cells.

3. A multi-plane random access memory system according to Claim 1, wherein said random access memory planes are comprised of arrays of static memory cells.

4. A multi-plane random access memory system according to Claim 1, wherein:
said random access memory planes are dynamic memory planes comprised of dynamic memory cells;
said copying means is comprised of a plurality of common bit lines each corresponding to a particular bit line in each of said memory planes to define a data transfer path between the corresponding bit lines in said memory planes, and a plurality of copy cell arrays each corresponding to one of said arrays of memory cells; and
each copy cell array comprises a plurality of copy cells equal in number to the number of bit lines of the memory cell array to which said copy cell array corresponds, each copy cell having a data signal input, a data signal output and an enable signal input, and each copy cell connected with its data signal input connected to its corresponding bit line, its data signal output connected to the common bit line corresponding to the bit line to which said copy cell is connected, and said enable signal input receiving in use an enabling signal for enabling a copy cell to connect its corresponding bit line to its corresponding common bit line for completing a data transfer path between the corresponding bit line and common bit line.

5. A multi-plane random access memory system according to Claim 4, wherein:
said random access memory planes are dynamic memory planes each comprised of an array of dynamic memory cells arranged in a matrix of rows and columns and comprising row lines and column lines for addressing individual memory cells of said memory cell array and bit lines for providing access to the respective memory cells being addressed;
each of said read/write means is comprised of row addressing means for addressing a row of said matrix, and column addressing means for simultaneously addressing a selectable number of columns of said matrix; and
said column addressing means comprising means responsive to a size signal for setting the number of columns to be addressed, means responsive to an address signal for generating address signals representing the addresses of the columns to be addressed, and means comprised of signal paths for applying the address signals to simultaneously enable the corresponding copy cells of the columns being addressed thereby connecting the bit lines of the addressed cells to their corresponding common bit lines.

6. A multi-plane random access memory system according to Claim 1, wherein:
said random access memory planes are static memory planes comprised of static memory cells;
said copying means is comprised of a plurality of common bit lines each corresponding to a particular memory cell in each of said memory planes to define a data transfer path between the corresponding memory cells in said memory planes, and a plurality of copy cell arrays each corresponding to one of said arrays of memory cells; and

EP 0 420 339 A2

each copy cell array comprises a plurality of copy cells equal in number to the number of memory cells of the memory cell array to which said copy cell array corresponds, each copy cell having a data signal input, a data signal output and an enable signal input, and each copy cell connected with its data signal input connected to its corresponding memory cell, its data signal output connected to the common bit line corresponding to the memory cell to which said copy cell is connected, and said enable signal input receiving in use an enabling signal for enabling a copy cell to connect its corresponding memory cell to its corresponding common bit line for completing a data transfer path between the corresponding memory cell and common bit line.

7. A multi-plane random access memory system according to Claim 6, wherein:
said random access memory planes are static memory planes each comprised of an array of static memory cells arranged in a matrix of rows and columns and comprising row lines and column lines for addressing individual memory cells of said memory cell array and bit lines for providing access to the respective memory cells being addressed;
each of said read/write means is comprised of row addressing means for addressing a row of said matrix, and column addressing means for simultaneously addressing a selectable number of columns of said matrix; and
said column addressing means comprising means responsive to a size signal for setting the number of columns to be addressed, means responsive to an address signal for generating address signals representing the addresses of the columns to be addressed, and means comprised of signal paths for applying the address signals to simultaneously enable the corresponding copy cells of the columns being addressed thereby connecting the bit cells of the addressed columns to their corresponding common bit lines.

8. A device for use in a multi-plane memory, comprising:
an array of memory cells arranged in a matrix of rows and columns and comprising row lines and column lines for addressing individual memory cells of said memory cell array and bit lines for providing access to the respective memory cells being addressed;
a plurality of common bit lines:
an array of copy cells connected to said bit lines of said memory cell array and to said common bit lines for passing signals from said bit lines to said common bit line sunder control of control signals applied to said array of copy cells;
row addressing means for addressing the rows of said memory cell array;
column addressing means for simultaneously addressing a plurality of columns of said memory cell array and for addressing corresponding common bit lines of said copy cell array to determine which signals of said bit lines are passed from said memory cell array to said common bit lines; and
input/output control means for controlling the input and the output of said device.

9. A device according to Claim 8, wherein said copy cells comprising said array of copy cells are each comprised of a dual gate transistor having a pair of contacts for the principal conduction path of said transistor and a pair of gates for controlling the conductivity of said principal conduction path, and wherein one of said contacts is connected to a respective bit line and the other of said contacts is connected to a corresponding common bit line, and one of said gates is connected for receiving a column selection signal from said column decoder and the other of said gates is connected for receiving a copy command signal, whereby the simultaneous application of a column selection signal and a copy command signal to a copy cell is effective to establish a conductive path between a memory cell of a selected row and column and a copy cell of a corresponding column for writing the content of said memory cell into said copy cell.

10. A device according to Claim 8, wherein said column addressing means is comprised of
means comprised of an array of logic gates for decoding an address signal applied thereto and for generating column select signals for selecting columns of bit lines to be addressed, said means being responsive to control signals for determining which column select signals are to be generated; and
means responsive to a size signal for developing a size selection signal representative of the size determined by the size signal and for applying the size selection signal to said means in order to control the number of columns of the selected now which will be copied by said copy cell array.

11. In a multi-plane memory, a matrix of static memory cells, each said static memory cell comprising:
a bistable circuit having a pair of outputs wherein the value of one output is the complement of the other output value;
a pair of bit lines extending along a column of cells within a memory plane;
a plurality of common bit line pairs each extending between memory planes and between corresponding static memory cells within the respective memory planes;
a read amplifier having a pair of inputs connected for reading the respective output of said bistable circuits, a pair of outputs connected to the respective common bit lines and enable inputs of enabling said read

9

amplifier to read the outputs of said bistable circuit and to apply the output signal states to said bit lines; and

a write circuit responsive to write-enable signals for applying the outputs of said bistable circuit to said common bit lines to transfer the content of said memory cell comprised of said bistable circuit by said common bit lines to a corresponding memory cell in another memory plane.

12. A multi-plane random access memory system according to Claim 1, in combination with a plurality of processors, and means connecting each of said processors to a respective one of said memory planes of said multi-plane memory system to permit said processors to read and write to their respective memory planes independently of the other processors.

FIG.1A

FIG.1B

FIG.2

FIG.3

FIG.4

FIG.5

FIG.6